# EUROPEAN PATENT SPECIFICATION

(11) **EP 1 951 836 B1**
(45) Date of publication and mention of the grant of the patent: **14.09.2011**
(21) Application number: 06827563.5
(22) Date of filing: 07.11.2006
(51) Int. Cl.: C09J 163/00, C09J 9/02, C09J 11/00

(54) **ANISOTROPIC CONDUCTIVE ADHESIVE COMPOSITIONS**
ANISOTROPE LEITFÄHIGE KLEBSTOFFE
COMPOSITIONS D ADHÉSIF CONDUCTEUR ANISOTROPE

(30) Priority: 23.11.2005 US 739569 P
(43) Date of publication of application: 06.08.2008
(73) Proprietor: 3M Innovative Properties Company, St. Paul, MN 55133-3427 (US)
(72) Inventor: CONNELL, Glen, Saint Paul, MN 55133-3427 (US); KROPP, Michael A., Saint Paul, MN 55133-3427 (US); LARSON, Eric G., Saint Paul, MN 55133-3427 (US)
(74) Representative: Reinhard - Skuhra - Weise & Partner GbR
(86) International application number: PCT/US2006/043198
(87) International publication number: WO 2007/061613

(56) References cited:
- EP-A1- 1 584 657
- WO-A1-2006/055161
- JP-A- 05 065 391
- JP-A- 2005 126 658
- US-A- 4 942 201
- US-A1- 2003 216 505
- US-A1- 2003 236 362
- US-A1- 2003 236 362
- DATABASE WPI Week 200428 Thomson Scientific, London, GB; AN 2004-298276 XP002580002 -& JP 2004 059827 A (TOKYO THREE BOND CO LTD) 26 February 2004 (2004-02-26)
- DATABASE WPI Week 200610 Thomson Scientific, London, GB; AN 2006-096695 XP002580003 & JP 2006 023419 A (SHINETSU CHEM IND CO LTD) 26 January 2006 (2006-01-26)

## Description

This application claims the benefit of U.S. Provisional Patent Application No. 60/739,569, filed November 23, 2005 .

### Background

The present invention relates to anisotropically conductive adhesives and adhesive compositions.

An adhesive that has the ability to establish multiple, discreet electrical connections between two electrical components is commonly referred to as an anisotropically conductive adhesive. Such adhesives are typically used to provide electrical connection between a flexible circuit and an electrical substrate. An anisotropically conductive adhesive composition should also provide a short bond time, adhere to a variety of substrates, provide a bondline without voids, have satisfactory shelf and storage life, and maintain the physical connection between a flexible circuit and an electrical substrate. The anisotropically conductive adhesive composition should also be easy to manufacture and use.

Some anisotropically conductive adhesive compositions have used microencapsulated imidazoles as thermally activated curing agents. These anisotropically conductive adhesive compositions typically have a shelf life of approximately one week at room temperature. Such adhesive compositions are typically complicated to manufacture because solvent needs to be removed without initiating the cure by the imidazole curatives. If the solvent is not removed completely from such adhesive compositions, voids can result in the subsequent bonding operations. Voids in the bondline can reduce the reliability of the electrical connection during use and can also reduce the adhesion strength of the bonded electrical components. If solvent removal is protracted, the shelf life may be reduced due to partial release of the imidazole. Voids in the bondline may also result from a too low of a viscosity in the adhesive composition prior to cure. Increasing the viscosity of the uncured anisotropically conductive adhesive composition and/or utilizing a curative that is operational at a lower temperature are known methods to reduce voids. However, higher viscosity formulations require more solvent and therefore longer steps to remove the solvent completely. Also, if the viscosity is too high, the coating solution may not wet the substrate, resulting in poor adhesion to the substrate. Lower temperature curatives can compromise both shelf stability and the manufacturing process.

### Summary

In one embodiment, the invention provides an adhesive composition comprising a mixture of: a multifunctional glycidyl ether epoxy resin; phenoxy resin; a core-shell polymer; optionally a thermoplastic resin; a thermally activated curing agent; and electrically conductive particles.

In another embodiment, the invention provides a curable adhesive paste comprising the adhesive composition above.

In another embodiment, the invention provides a curable adhesive film comprising the adhesive composition above.

In another embodiment, the invention provides a tape comprising a curable adhesive film of the invention on a liner.

In another embodiment, the invention provides a flexible circuit comprising a flexible printed circuit and an adhesive composition according to the invention adhered to the flexible printed circuit.

### Detailed Description

"Thermoplastic resin" means a resin that softens when exposed to heat and returns to its original condition when cooled to room temperature.

"Parts by weight " (pbw) means parts of a resin component per weight of the total amount of multifunctional glycidyl ether epoxy resin, phenoxy resin, core-shell polymer, thermoplastic resin (if present), and thermally activated curing agents.

The adhesive compositions of the invention advantageously provide bonds between flexible circuits and electrical components without voids in the bondline, which leads to stable and reliable electrical and adhesion properties.

The formulations of the present invention overcome the limitations of short shelf life and voids in the bondline. In some embodiments, the formulations of the present invention utilize latent imidazole curatives that are solids at room temperature and that are insoluble in the anisotropically conductive adhesive composition until the latent imidazole curative melts and then dissolves at a temperature of about 120 °C. The latent imidazole curatives provide a large process window for solvent removal and improved shelf life. In addition, the present invention includes a core-shell polymer, that surprisingly eliminates void formation in the bonding process when it is incorporated at a level of at least about 15, desirably at least about 20 weight percent or greater.

Specific examples of multifunctional glycidyl ether epoxy resins useful in the compositions of the present invention include, but are not limited to, diglycidyl ethers of bisphenol A and diglycidyl ethers of bisphenol F.

Examples of useful multifunctional glycidyl ether epoxy resins that are diglycidyl ethers of bisphenol A include, but are not limited to, those having the trade designations EPON Resins 825, 826, and 828, available from Resolution Performance Products, Houston, TX; D.E.R. 330, 331, and 332 resins, available from Dow Chemical Company, Midland, MI; and ARALDITE GY 6008, GY 6010, and GY 2600 resins, available from Vantico, Brewster, NY.

Examples of useful multifunctional glycidyl ether epoxy resins that are diglycidyl ethers of bisphenol F include, but are not limited to those having the trade designations EPON Resin 862 resin, available from Resolution Performance Products, Houston, TX; and ARALDITE GY 281, GY 282, GY 285, PY 306, and PY 307 resins, available from Huntsman Chemical, East Lansing, MI.

The multifunctional glycidyl ether epoxy resin is present in the adhesive compositions of the invention at an amount from about 20 to about 65 pbw. In other embodiments, the multifunctional glycidyl ether epoxy resin is present in the adhesive compositions from about 30 to about 60 pbw. Other adhesive compositions of the invention may contain any amount or any range of amount between 20 and 65 pbw multifunctional glycidyl ether epoxy.

Other useful multifunctional glycidyl ether epoxy resins include those epoxy resins having more than 2 glycidyl groups on average within a molecule. Specific examples of the glycidyl ether epoxy resin include multifunctional phenol novolak-type epoxy resins (synthesized by reacting phenol novolak with epichlorohydrin) cresol novolak epoxy resin, and bisphenol A novolak epoxy resins. Examples of commercially available multifunctional glycidyl ether epoxy resins include those epoxy resins having the trade designations EPON 1050, EPON 160, EPON 164, EPON 1031, EPON SU-2.5, EPON SU-3, and EPON SU-8, available from Resolution Performance Products, Houston, TX; the "DEN" series of epoxy resins, available from Dow Chemical, Midland MI; and TACTIX 756, and TACTIX 556 epoxy resin, available from Huntsman Chemical, East Lansing, MI.

The multifunctional glycidyl ether epoxy resin usually has an epoxy equivalent weight of from about 170 to about 500, in other embodiments, from about 170 to about 350, and in other embodiments from about 170 to about 250. Ranges for the average epoxy functionality include from 1.5 to 10.

The core-shell polymer of the present invention is typically a polymer particle comprising a first polymer as the inner core, and a second polymer as a shell surrounding the inner core polymer. The core-shell polymer of the current invention comprises a core phase polymer that is a rubbery polymer and a shell phase polymer that is non-rubbery polymer. In addition, the shell phase non-rubbery polymer has carboxylic acid functional groups in the polymer. As an example, the core phase rubbery polymer may be crosslinked acrylic rubber, polybutadiene-styrene rubber, and silicone rubber. The shell phase non-rubbery polymer preferably has a softening point of 60 to 150°C. An example of core-shell polymer that has a core phase polymer that is a rubbery polymer and a shell phase polymer that is a non-rubbery and that has carboxylic acid functional groups on the shell phase non-rubbery polymer has the trade designation ZEON F-351, a product manufactured by Nippon Zeon Co. Ltd, JP. The core shell polymer is present in the compositions of the invention at levels of about 15 to about 30 pbw, and in other embodiments, from about 20 to about 25 pbw. Other adhesive compositions of the invention may contain any amount or any range of amount between 15 and 30 pbw core shell polymer.

The phenoxy resin used in the compositions of the invention is a high molecular weight copolymer of bisphenol A and epichlorohydrin and contains no epoxy groups. Commercially available phenoxy resins include those having the trade designations PKHB, PKHC, PKHH, PKHJ, PKHE resins available from InChem, Rock Hill, SC. The phenoxy resin is present in the compositions of the invention at levels of about 20 to about 45 pbw, and in other embodiments, from about 25 to about 40 pbw. Other adhesive compositions of the invention may contain any amount or any range of amount between 20 and 45 pbw phenoxy resin.

If present, thermoplastic oligomeric or polymeric resins useful in the anisotropically conductive adhesive compositions are film forming resins and in some cases permit rework of a bond using an appropriate solvent. The thermoplastic resins include those semi-crystalline materials that have melting points. Suitable thermoplastic resins are soluble in solvents such as tetrahydrofuran (THF) or methyl ethyl ketone (MEK) and exhibit an initial compatibility with the epoxy resin used. This compatibility allows the blend of epoxy resin and thermoplastic resin to be solvent cast without phase separating. Nonlimiting examples of thermoplastic resins having these characteristics and useful in this invention include polyesters, co-polyesters, acrylic and methacrylic resins, and novolac resins. It is also within the scope of this invention to use a blend of more than one thermoplastic oligomeric or polymeric resin in preparing the adhesive compositions.

The thermoplastic resin may be present in the adhesive compositions of the invention at an amount from 0 to about 20 pbw. In other embodiments, the adhesive compositions of the invention contain from about 1 to about 10 pbw thermoplastic resin. Other embodiments of the adhesive compositions of the invention may contain any amount or any range of amount between 0 and 20 pbw thermoplastic resin.

The compositions of the present invention contain one or more thermally activated curing agents. The function of the thermally activated curing agents in the compositions of the invention is to accelerate curing of the epoxy resin. Useful thermally activated curing agents are those that promote epoxy homopolymerization as well as the coreaction of the phenoxy resin with the multifunctional glycidyl ether epoxy resin. Additionally, useful thermally activated curing agents are latent, that is nonreactive, at ambient temperature conditions, but are activated to accelerate epoxy cure reactions when heated above a temperature of 120°C or greater. Thermally activated curing agents include substituted imidazoles, such as 2-[beta-[2'-methylimidazolyl-(1')}]-ethyl-4.6-diamino-s-triazine

(2MZ-A), 2,4-diamino-6-6[2'-methylimidazolyl-(1')]-ethyl-s-triazine isocyanurate adduct (2MA-OK), as provided by the Shikoku Company, JP and 4,5-diphenylimidazole and combinations thereof. Additional thermally activated curing agents for epoxy resins are transition metal salt complexes of imidazole and substituted imidazoles, such as 1-methylimidazole/Cu(NO₃)₂ .H₂0 complex, 1-benzylimidazole/ Cu(NO₃)₂ .H₂0, 1-benzyl-2-methylimidazole/ Cu(NO₃)₂ .H₂0, 1-methylimidazole/ Zn(NO₃)₂ .H₂0, 1-methylimidazole/Ni(NO₃)₂ .H₂0. Finally, thermally activated curing agents for epoxy resins can include metal imidazolates, such as zinc imidazolate and copper imidazolate.

The thermally activated curing agent is present in the adhesive compositions in an effective amount. Thermally activated curing agent can be present in an amount in the range of from about 1 to about 10 pbw and in other embodiments from about 1 to about 7 pbw. Thermally activated curing agent may also be present in any amount or range of amounts between 1 and 10 pbw.

The electrically conductive particles used may be conductive particles such as carbon particles or metal particles of silver, copper, nickel, gold, tin, zinc, platinum, palladium, iron, tungsten, molybdenum, solder or the like, or particles prepared by covering the surface of these particles with a conductive coating of a metal or the like. It is also possible to use non-conductive particles of a polymer such as polyethylene, polystyrene, phenol resin, epoxy resin, acryl resin or benzoguanamine resin, or glass beads, silica, graphite or a ceramic, whose surfaces have been covered with a conductive coating of a metal or the like.

The electrically conductive particles are found in a variety of shapes (spherical, ellipsoidal, cylindrical, flakes, needle, whisker, platelet, agglomerate, crystal, acicular). The particle may have a slightly rough or spiked surface. The shape of the electrically conductive particles is not particularly limited but a nearly spherical shape is usually preferred. The choice of shape is typically dependent upon the rheology of the selected resin components and ease of processing of the final resin/particle mix. Combinations of particle shapes, sizes, and hardness may be used in the compositions of the invention.

The mean particle size of the conductive particles used may vary depending on the electrode width and the spacing between the adjacent electrodes used for connection. For example, if the electrode width is 50 micrometers and the spacing between adjacent electrodes is 50 micrometers (that is, the electrode pitch is 100 micrometers), a mean particle size of about 3 to about 20 micrometers is appropriate. By using an anisotropically conductive adhesive composition in which are dispersed conductive particles with a mean particle size in this range, it is possible to achieve fully satisfactory conductive characteristics while also adequately preventing short circuiting between adjacent electrodes. In most cases, since the pitch of the electrodes used for connection between the two circuit substrates will be from about 50 to about 1000 micrometers, the mean particle size of the conductive particles is preferably in the range of about 2 to about 40 micrometers. If they are smaller than about 2 micrometers, they may be buried in pits in the electrode surface thus losing their function as conductive particles, and if they are larger about 40 micrometers, they may tend to produce short circuiting between adjacent electrodes. _

The amount of the conductive particles added may vary depending on the area of the electrodes used and the mean particle size of the conductive particles. A satisfactory connection can usually be achieved with a few (for example, about 2 to about 10) conductive particles present per electrode. For even lower electrical resistance, the conductive particles may be included in the composition at about 10 to about 300 per electrode.

The amount of conductive particles with respect to the total volume of the composition minus the conductive particles is usually about 0.1 to about 30% by volume, in other embodiments about 0.5 to about 10% by volume and in other embodiments, about 1 to about 5% by volume.

In one embodiment of the invention, an adhesive composition comprises a multifunctional glycidyl ether epoxy resin, a phenoxy resin, a core-shell polymer, a thermally activated curing agent, and electrically conductive particles. In this embodiment, core-shell polymers with a core phase polymer that is a rubbery polymer and a shell phase polymer that is non-rubbery and that has carboxylic acid functional groups on the shell phase non-rubbery polymer are desirable to use in the adhesive composition.

Adjuvants may optionally be added to the compositions such as colorants, antioxidants, flow agents, bodying agents, flatting agents, silane coupling agents, inert fillers, binders, blowing agents, fungicides, bactericides, surfactants, plasticizers, and other additives known to those skilled in the art. They can be also substantially unreactive, such as fillers both inorganic and organic. These adjuvants, if present, are added in an amount effective for their art known purpose.

Typically, the adhesive composition of the invention will be solvent or hot-melt coated onto a release liner and used as a transfer adhesive film such that the adhesive film can be adhered to a substrate and the liner removed. A typical use for the anisotropically conductive adhesives described herein is to provide a connection between a flexible printed circuit and a circuit board, for example those found in a flat panel display. Other potential applications include flipchip attachment of unpackaged silicon chips to various printed circuit substrates and interconnections between two flexible printed circuits or any combinations thereof. Suitable substrates useful to provide articles of the invention include, for example, metals (for example, aluminum, copper, cadmium, zinc, nickel, gold, platinum, silver), glass, various thermoplastic or thermoset films (for example, polyethylene terephthalate, plasticized polyvinyl chloride, polypropylene, polyethylene), ceramics, cellulosics, such as cellulose acetate, and epoxides (circuit boards).

The amount of heat required for polymerization and the amount of the curing agent used will vary depending on the particular polymerizable composition used and the desired application of the polymerized product. Suitable sources of heat to cure the compositions of the invention include induction heating coils, hot bar bonders, ovens, hot plates, heat guns, IR sources including lasers, microwave sources, and the like.

Advantages of this invention are further illustrated by the following examples, but the particular materials and amounts thereof recited in these examples, as well as other conditions and details, should not be construed to unduly limit this invention. All materials are commercially available or known to those skilled in the art unless otherwise stated or apparent.

### Examples

In the test methods and examples below, the sample dimensions are approximate.

### Test Methods

### Electrical Resistance

A 28 mm wide by 22 mm long by 25 micrometers thick polyimide flexible circuit having 101 traces that were gold over nickel over copper, obtained from Flexible Circuit Technologies Incorporated, Minneapolis, MN, was removed from a drying oven set at 80 °C. The traces were 100 micrometers in width with 100 micrometer spacing and a height of no greater than 18 micrometers. An approximately 30 mm long strip of the film composition to be tested was cut from a film sample that had a liner on both sides of the film. One of the liners was removed and the exposed side of the film was tacked to the flexible circuit by rolling with a roller to ensure smooth application and eliminate any entrapped air. The excess sample film was trimmed to the edge of the flexible circuit to form a film/flexible circuit laminate. The remaining liner was carefully removed without disturbing the film bond to the flexible circuit.

A 46 mm wide by 76 mm long by 1.4 mm thick FR4 printed circuit board with the same traces as the flexible circuit, available from Nationwide Circuits Inc., Rochester, New York, was removed from a drying oven set at 80 °C. The film/flexible circuit laminate was placed on the circuit board making sure that each trace of the film/flexible circuit laminate was aligned properly with each trace of the printed circuit board and rolled down with a roller to ensure smooth application and eliminate any entrapped air. A strip, approximately 50 mm long, of the FujiPoly Sarcon 20GTR thermally conductive rubber, available from FujiPoly America Corporation, Carteret, NJ, was laid over the bond area of the joined sample.

A MicroJoin 4000 pulse heat bonder, manufactured by MicroJoin Inc. (now Miyachi Unitek Corporation, Monrovia, CA) with a 2 mm wide thermode was used to make the bond. The bonder was set to achieve a measured temperature of 160°C (thermocouple) in the bond line for 10 seconds and a pressure of 2 MPa. The resultant connection area for each trace was 100 micrometers by 2 mm. The bonded samples were aged for about 16 hours at ambient conditions.

Electrical resistance of the bonded samples was determined using a 4-Point Kelvin Measurement technique using the following components/settings:
Power source/voltmeter = Model 236 Source-Measure Unit, available from Keithley Instruments, Inc., Cleveland, OH
Switching matrix = Integra Series Switch/Control Module Model 7001, available from Keithley Instruments, Inc.
Probe station = Circuit Check PCB-PET, available from Circuit Check Inc, Maple Grove, MN
PC software = LabVIEW
Test current = 100 milliamps (mA)
Sense compliance (volts) = 2.000
Max. Measurable resistance = 20.000 Ohms

The bonded samples were placed in the probe station, and 15 measurements were taken on each sample.

One example was placed into a heat and humidity controlled chamber set at 85 °C and 85% relative humidity (RH). After 100, 250, 500, and 1000 hours, the bonded sample was taken out of the chamber, allowed to equilibrate to room conditions for at least two hours and then tested for electrical resistance. The results are shown below in Table 4.

### 90 Degree Peel Adhesion

Bonded samples were prepared as described above for test method "Electrical Resistance".

The bonded samples were tested for 90 degree peel adhesion using an INSTRON 1122 Tensile Tester upgraded with MTS RENEW software, available from MTS Systems Corporation, Eden Prairie, MN, fitted with a 50 lb. Load cell, and a 90 degree peel test fixture. The peel rate was 25 mm/minute. The peak peel value was recorded in grams force per centimeter (g_{f}/cm). One to three replicates were tested for each test composition. The peak peel values of the replicates were averaged and reported as the peak peel value for each composition.

The following examples were conducted using the materials shown in Table 1 below.

### Bond line Appearance

Bonded samples were prepared as described above for test method "Electrical Resistance". The bonding area of each sample was examined using an Olympus stereomicroscope model SZX9 at 50x magnification. Voids and bubbles were counted and then each sample was given a rating from 1 to 5, with 1 = large voids in nearly every bond trace to 5 = no voids or bubbles present in any of the bond traces.

### Glossary

The following examples were conducted using the materials shown in Table 1 below.

**Table 1**

| Trade Designation/ Material | Source | Description |
|---|---|---|
| **Core-shell polymer** | | |
| F351 | Nippon Zeon Company, Tokyo, JP | core: cross linked acrylic rubber, shell: acid functional polymethylmethacrylate copolymer |
| PARALOID EXL 2691 | Rohm and Haas Co., Philadelphia, PA | Core: polybutadiene-styrene rubber, shell: polymethylmethacrylate |
| PARALOID EXL 2314 | Rohm and Haas Co., Philadelphia, PA | Core: polybutyl acrylate rubber, shell: polymethylmethacrylate |
| GENIOPERL P23 | Wacker-Chemie, Munich, DE | Core: silicone rubber, shell: epoxy functional polymethylmethacrylate copolymer |
| **Digylicdyl ether Resin** | | |
| EPON 828 | Resolution Performance Products, Houston, TX | Diglcidyl ether ofbisphenol A epoxide equivalent weight 185-195 |
| **Phenoxy Resin** | | |
| INCHEMREZ PKHJ | InChem Corp., Rock Hill, SC | Solid phenoxy resin, Tg (DSC) 95 °C, Melt Index @ 200°C<4g/10min |
| **Electrically Conductive Particles** | | |
| 7GNM8-NiC | JCI USA Inc., White Plains, NY | 7 wt. % gold-coated nickel particles, average mean size 8 micrometers |
| **Thermally Activated Curing agent** | | |
| CUREZOL 2 MZ Azine | Air Products and Chemicals Inc. Allentown, PA s-triazine, | 2,4- Diamino - 6(2'-methylimidazoleyl-(1')) ethyl- |

### General Procedure for preparing films

In a closed vessel, the INCHEMREZ PKHJ resin was dissolved in the methyl ethyl ketone (MEK) solvent. In an open vessel, core-shell polymer was dispersed into the EPON 828 resin. In an open vessel these two solutions were combined and mixed to a uniform dispersion (amounts of each given in Table 2 for each example.) Finally, the CUREZOL 2 MZ Azine and the gold-coated Nickel particles (7GNM8-Ni) were added and mixing was continued to provide a uniform dispersion for coating.

A 40-45 micrometer thick film was prepared by placing the adhesive composition onto a release coated polyethylene terephthalate (PET) film liner, drawing the adhesive composition past a knife edge, and then drying the coated adhesive composition in a forced air oven at 70 °C for 8 minutes.

The films were tested for electrical resistance, peel adhesion, and bondline appearance according to the test methods outlined above. The results from the testing are compiled below in Table 3.

**Table 2**

| **Component** | Ex. 1 | Ex. 2 | Ex. 3 | Ex. 4 | Ex. 5 | Ex. 6 | Comp. Ex. 1 | Comp. Ex. 2 | Comp. Ex. 3 |
|---|---|---|---|---|---|---|---|---|---|
| EPON 828 (g) | 11.2 | 8 | 11.2 | 8 | 9.6 | 8 | 9.6 | 9.6 | 9.6 |
| INCHEMREZ PKHJ (g) | 5.8 | 7 | 3.8 | 9 | 6.4 | 8 | 6.4 | 6.4 | 6.4 |
| F351 (g) | 3 | 5 | 5 | 3 | 4 | 4 | 0 | 0 | 0 |
| PARALOID EXL 2314 (g) | 0 | 0 | 0 | 0 | 0 | 0 | 0 | 4 | 0 |
| PARALOID EXL 2691 (g) | 0 | 0 | 0 | 0 | 0 | 0 | 0 | 0 | 4 |
| GENIOPERL P23 (g) | 0 | 0 | 0 | 0 | 0 | 0 | 4 | 0 | 0 |
| CUREZOL 2 MZ Azine (g) | 0.85 | 0.75 | 0.75 | 0.85 | 0.8 | 0.8 | 0.8 | 0.8 | 0.8 |
| 7GNM8-Ni (g) | 2.6 | 2.6 | 2.6 | 2.6 | 2.6 | 2.6 | 2.6 | 2.6 | 2.6 |
| MEK (g) | 15 | 15 | 15 | 15 | 15 | 15 | 15 | 15 | 15 |

**Table 3**

| Example | Electrical resistance (mOhms) | Peel Adhesion (g_{f}/cm) | Bondline (Appearance) |
|---|---|---|---|
| 1 | 4.1 | 890 | 2 |
| 2 | 3.7 | 1030 | 5 |
| 3 | 3.3 | 640 | 4 |
| 4 | 4.4 | 960 | 2 |
| 5 | 3.4 | 1060 | 5 |
| 6 | 4.1 | 1080 | 5 |
| Comp. 1 | 3.0 | 670 | 1 |
| Comp. 2 | 2.5 | 760 | 2 |
| Comp.3 | 3.3 | 650 | 2 |

**Table 4**

| Example | Electrical Resistance mOhms | Initial | Aged 100 hours 85 °C/85%RH | Aged 250 hours 85 °C/85%RH | Aged 500 hours 85 °C/85%RH | Aged 1000 hours 85 °C/85%RH |
|---|---|---|---|---|---|---|
| 5 | Average | 3.4 | 4.5 | 4.9 | 5.0 | 5.1 |

## Claims

1. An adhesive composition comprising a mixture of:
a multifunctional glycidyl ether epoxy resin;
a phenoxy resin, containing no epoxy groups;
a core-shell polymer comprising a core phase polymer and a shell phase polymer, and the shell phase polymer comprising a non-rubbery polymer having carboxylic acid functional groups;
optionally, a thermoplastic resin;
a thermally activated curing agent; and
electrically conductive particles.

2. The adhesive composition of claim 1 wherein the thermally activated curing agent is solid at room temperature.

3. The adhesive composition of claim 2 wherein the thermally activated curing agent is activated when heated above a temperature of 120 °C or greater.

4. The adhesive composition of claim 2 wherein the thermally activated curing agent is a substituted imidazole.

5. The adhesive composition of claim 1 wherein the thermally activated curing agent is 2-[beta-[2'-methylimidazolyl-(1')]]-ethyl-4.6-diamino-s-triazine; 2,4-diamino-6-6[2'-methylimidazolyl-(1')]-ethyl-s-triazine isocyanurate adduct; and 4,5-diphenylimidazole or combinations thereof.

6. The adhesive composition of claim 1 wherein the core-shell polymer is present in the composition at a level of from about 15 pbw to about 30 pbw.

7. The adhesive composition of claim 1 wherein the core-shell polymer is present in the composition at a level of from about 20 pbw to about 30 pbw.

8. A curable adhesive film comprising the adhesive composition of claim 1.

9. The curable adhesive film according to claim 8 wherein the adhesive film has a thickness of from about 5 to about 100 micrometers.

10. A tape comprising the curable adhesive film of claim 8 on a liner.

11. A sheet comprising the curable adhesive film of claim 8 on a liner.

12. A flexible circuit comprising a flexible printed circuit and the adhesive composition according to claim 1 adhered to the flexible printed circuit.

## Patentansprüche

1. Klebstoffzusammensetzung, umfassend eine Mischung von:
einem multifunktionellen Glycidyletherepoxidharz;
einem Phenoxyharz, das keine Epoxidgruppen enthält;
einem Kern-Schale-Polymer, das ein Kernphasenpolymer und ein Schalenphasenpolymer, wobei das Schalenphasenpolymer ein nicht kautschukartiges Polymer mit carbonsäurefunktionellen Gruppen umfaßt;
gegebenenfalls einem thermoplastischen Harz;
einem thermisch aktivierten Härtungsmittel und
elektrisch leitfähigen Teilchen.

2. Klebstoffzusammensetzung nach Anspruch 1, wobei das thermisch aktivierte Härtungsmittel bei Raumtemperatur fest ist.

3. Klebstoffzusammensetzung nach Anspruch 2, wobei das thermisch aktivierte Härtungsmittel beim Erhitzen über eine Temperatur von 120°C oder mehr aktiviert wird.

4. Klebstoffzusammensetzung nach Anspruch 2, wobei es sich bei dem thermisch aktivierten Härtungsmittel um ein substituiertes Imidazol handelt.

5. Klebstoffzusammensetzung nach Anspruch 1, wobei es sich bei dem thermisch aktivierten Härtungsmittel um 2-[beta-[2'-Methylimidazolyl-(1')]]-ethyl-4,6-diamino-s-triazin; 2,4-Diamino-6-6[2'-methylimidazolyl-(1')]-ethyl-s-triazin-Isocyanurat-Addukt und 4,5-Diphenylimidazol oder Kombinationen davon handelt.

6. Klebstoffzusammensetzung nach Anspruch 1, wobei das Kern-Schale-Polymer in der Zusammensetzung in einer Menge von etwa 15 Gewichtsteil bis etwa 30 Gewichtsteil vorliegt.

7. Klebstoffzusammensetzung nach Anspruch 1, wobei das Kern-Schale-Polymer in der Zusammensetzung in einer Menge von etwa 20 Gewichtsteil bis etwa 30 Gewichtsteil vorliegt.

8. Härtbarer Klebstoff-Film, umfassend die Klebstoffzusammensetzung nach Anspruch 1.

9. Härtbarer Klebstoff-Film nach Anspruch 8, wobei der Klebstoff-Film eine Dicke von etwa 5 bis etwa 100 Mikrometer aufweist.

10. Band, umfassend den härtbaren Klebstoff-Film nach Anspruch 8 auf einem Liner.

11. Folie, umfassend den härtbaren Klebstoff-Film nach Anspruch 8 auf einem Liner.

12. Flexible Schaltung, umfassend eine flexible gedruckte Schaltung und die haftend darauf aufgebrachte Klebstoffzusammensetzung nach Anspruch 1.

## Revendications

1. Composition adhésive comprenant un mélange de :
une résine époxy éther glycidylique multifonctionnelle ;
une résine phénoxy, ne contenant pas de groupes époxy ;
un polymère noyau-enveloppe comprenant un polymère de phase noyau et un polymère de phase enveloppe, le polymère de phase enveloppe comprenant un polymère non caoutchouteux qui contient des groupes fonctionnels acide carboxylique ;
éventuellement, une résine thermoplastique ;
un agent de durcissement activé thermiquement ; et
des particules électriquement conductrices.

2. Composition adhésive selon la revendication 1, dans laquelle l'agent de durcissement activé thermiquement est solide à température ambiante.

3. Composition adhésive selon la revendication 2, dans laquelle l'agent de durcissement activé thermiquement est activé lorsqu'il est chauffé au-dessus d'une température de 120 °C ou plus.

4. Composition adhésive selon la revendication 2, dans laquelle l'agent de durcissement activé thermiquement est un imidazole substitué.

5. Composition adhésive selon la revendication 1, dans laquelle l'agent de durcissement activé thermiquement est la 2-[bêta-[2'-méthylimidazolyl-(1')]]-éthyl-4,6-diamino-s-triazine ; un adduit d'isocyanurate de 2,4-diamino-6-6[2'-méthylimidazolyl-(1')]-éthyl-s-triazine ; et le 4,5-diphénylimidazole ou leurs combinaisons.

6. Composition adhésive selon la revendication 1, dans laquelle le polymère noyau-enveloppe est présent dans la composition à un niveau d'environ 15 parties en poids à environ 30 parties en poids.

7. Composition adhésive selon la revendication 1, dans laquelle le polymère noyau-enveloppe est présent dans la composition à un niveau d'environ 20 parties en poids à environ 30 parties en poids.

8. Film adhésif durcissable comprenant la composition adhésive selon la revendication 1.

9. Film adhésif durcissable selon la revendication 8, dans lequel le film adhésif a une épaisseur d'environ 5 à environ 100 micromètres.

10. Ruban comprenant le film adhésif durcissable selon la revendication 8 sur une doublure.

11. Feuille comprenant le film adhésif durcissable selon la revendication 8 sur une doublure.

12. Circuit flexible comprenant un circuit imprimé flexible et la composition adhésive selon la revendication 1 adhérée sur le circuit imprimé flexible.
